# EUROPEAN PATENT APPLICATION

(11) **EP 4 686 093 A1**
(43) Date of publication of application: **28.01.2026**
(21) Application number: 25190017.1
(22) Date of filing: 16.07.2025
(51) Int. Cl.: H03F 1/02, H03F 3/195, H03F 3/24, H03G 3/30, H04B 1/04

(54) **RADIO-FREQUENCY AMPLIFIER WITH MULTIPLE POWER CONTROL LOOPS**

(30) Priority: 23.07.2024 US 202418780907; 23.07.2024 US 202418780965
(71) Applicant: Apple Inc., Cupertino, CA 95014 (US)
(72) Inventor: FREIMAN, Amit, Cupertino, 95014 (US); PALASKAS, Georgios, Cupertino, 95014 (US); CAMUFFO, Andrea, Cupertino, 95014 (US); PATANE, Giuseppe, Cupertino, 95014 (US)
(74) Representative: Froud, Christopher Andrew

(57) **Abstract**

Wireless circuitry (24) can include a radio-frequency amplifier (50) configured to operate in a plurality of different mode settings, a power detector (70-TX) coupled to an output of the radio-frequency amplifier (50), a plurality of power integrators (140-1, 140-N), a switching circuit (112) receiving a measured power level from the power detector (70-TX) and having outputs coupled to the plurality of power integrators (140-1, 140-N). The switching circuit (112) can have a switch state that is adjusted based on a mode setting for the radio-frequency amplifier (50). The power integrators (140-1, 140-N) may be part of multiple power control loops. The power control loops can be coupled to additional switching circuitry (110, 114, 116) activated based at least party on the mode setting and a subsequent mode setting for the radio-frequency amplifier (50).

## Description

This application claims priority to U.S. patent application No. 18/780,907, filed July 23, 2024, and U.S. patent application No. 18/780,965, filed July 23, 2024.

### Field

This disclosure relates generally to electronic devices and, more particularly, to electronic devices with wireless communications circuitry.

### Background

Electronic devices can be provided with wireless communications capabilities. An electronic device with wireless communications capabilities has wireless communications circuitry with one or more antennas. Wireless transceiver circuitry in the wireless communications circuitry uses the antennas to transmit and receive radio-frequency signals.

Radio-frequency signals transmitted by an antenna can be fed through a power amplifier, which is configured to amplify low power analog signals to higher power signals more suitable for transmission through the air over long distances. Radio-frequency signals received at an antenna can be fed through a low noise amplifier, which is configured to amplify low power analog signals to higher power signals for ease of processing at a receiver. It can be challenging to design a satisfactory radio-frequency amplifier for an electronic device.

### Summary

An aspect of the disclosure provides wireless circuitry that includes one or more transmit circuits operable using a plurality of different mode settings, a power detection circuit coupled to an output the one or more transmit circuits, a plurality of power integrators, and a first switching circuit having an input configured to receive a measured power level from the power detection circuit and having outputs coupled to the plurality of power integrators, wherein the first switching circuit has a switch state that is adjusted based on a current mode setting in the plurality of different mode settings for the one or more transmit circuits.

An aspect of the disclosure provides wireless circuitry that includes a radio-frequency amplifier operable using a plurality of different bias settings, a power detection circuit coupled to an output of the radio-frequency amplifier, a plurality of power integrators, and a first switching circuit having an input configured to receive a measured power level from the power detection circuit and having outputs coupled to the plurality of power integrators. The first switching circuit can have a switch state that is adjusted based on a current bias setting in the plurality of different bias settings for the radio-frequency amplifier.

An aspect of the disclosure provides circuitry that includes a signal path having one or more amplifier stages, a gain control circuit configured to attenuate or amplify signals along the signal path, a bias controller for outputting a control word that determines a configuration setting for the one or more amplifier stages, and a plurality of power control loops. A selected power control loop in the plurality of power control loops can be activated based at least partly on the control word to provide a power correction signal to the one or more amplifier stages.

An aspect of the disclosure provides a method of operating wireless circuitry that includes operating one or more transmit circuits using a mode setting selected from among a plurality of mode settings, measuring a power level of the one or more transmit circuits with a power detector, conveying the measured power level from the power detector to a selected power control loop in a plurality of power control loops with a first switching circuit, and controlling the first switching circuit based on the mode setting currently being used to operate the one or more transmit circuits.

An aspect of the disclosure provides a method of operating wireless circuitry that includes operating a radio-frequency amplifier using a bias setting selected from among a plurality of bias settings, measuring a power level of the radio-frequency amplifier with a power detector, conveying the measured power level from the power detector to a selected power control loop in a plurality of power control loops with a first switching circuit, and controlling the first switching circuit based on the bias setting currently being used to operate the radio-frequency amplifier.

An aspect of the disclosure provides circuitry that includes means for operating one or more transmit circuits using a configuration setting selected from among a plurality of configuration settings, means for measuring a power level of the one or more transmit circuits, a switch for conveying the measured power level to a selected power control loop in a plurality of power control loops, and means for controlling the switch based on the configuration setting.

### Brief Description of the Drawings

FIG. 1 is a diagram of an illustrative electronic device having wireless circuitry in accordance with some embodiments.
FIG. 2 is a diagram of illustrative wireless circuitry having radio-frequency amplifiers in accordance with some embodiments.
FIG. 3 is a diagram showing illustrative power detectors coupled to radio-frequency amplifiers in accordance with some embodiments.
FIG. 4 is a diagram showing how different amplifier bias settings can be used for different operating conditions in accordance with some embodiments.
FIG. 5 is a diagram showing a radio-frequency amplifier coupled to a plurality of control loops for different bias settings in accordance with some embodiments.
FIG. 6 is flowchart of illustrative steps for operating the circuitry shown in FIG. 5 in accordance with some embodiments.

### Detailed Description

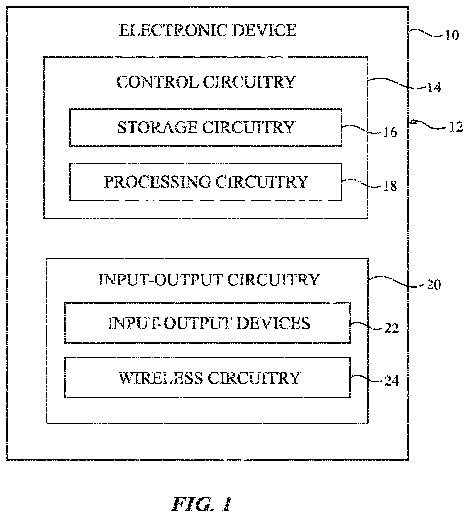

An electronic device such as device 10 of FIG. 1 may be provided with wireless circuitry with multiple control loops. Wireless circuitry can include radio-frequency amplifiers such as power amplifiers and low noise amplifiers. Power amplifiers can be used to amplify radio-frequency signals in a transmit path, whereas low noise amplifiers can be used to amplify radio-frequency signals in a receive path. Power detection circuits can be coupled to these radio-frequency amplifiers. A power detector coupled at an output of a radio-frequency power amplifier can be configured to run an adaptive power control algorithm for adjusting a power level of the power amplifier, whereas a power detector coupled at an output of a radio-frequency low noise amplifier can be used to run an automatic gain control algorithm for adjusting a power level of the low noise amplifier.

In accordance with some embodiments, a radio-frequency amplifier can be coupled to a power detector that is part of multiple control loops. Each of the multiple control loops can be used in conjunction with a different bias setting for the radio-frequency amplifier. Each of the various control loops can include a dedicated power integrator for the corresponding amplifier bias setting. The power integrator can be coupled to a comparator that compares the integrated power with a target power level associated with that bias setting. The comparator can output a correction signal that is used to adjust a gain for signals being fed to the radio-frequency amplifier. Configuring radio-frequency amplifier circuitry in this way can be technically advantageous and beneficial by allowing the radio-frequency amplifier to operate at different bias settings on a per-symbol basis while maintaining fast and accurate tracking of output power level.

Electronic device 10 of FIG. 1 can include amplifier circuitry with multiple control loops and may be a computing device such as a laptop computer, a desktop computer, a computer monitor containing an embedded computer, a tablet computer, a cellular telephone, a media player, or other handheld or portable electronic device, a smaller device such as a wristwatch device, a pendant device, a headphone or earpiece device, a device embedded in eyeglasses or other equipment worn on a user's head, or other wearable or miniature device, a television, a computer display that does not contain an embedded computer, a gaming device, a navigation device, an embedded system such as a system in which electronic equipment with a display is mounted in a kiosk or automobile, a wireless internet-connected voice-controlled speaker, a home entertainment device, a remote control device, a gaming controller, a peripheral user input device, a wireless base station or access point, equipment that implements the functionality of two or more of these devices, or other electronic equipment.

As shown in the functional block diagram of FIG. 1, device 10 may include components located on or within an electronic device housing such as housing 12. Housing 12, which may sometimes be referred to as a case, may be formed from plastic, glass, ceramics, fiber composites, metal (e.g., stainless steel, aluminum, metal alloys, etc.), other suitable materials, or a combination of these materials. In some embodiments, parts or all of housing 12 may be formed from dielectric or other low-conductivity material (e.g., glass, ceramic, plastic, sapphire, etc.). In other embodiments, housing 12 or at least some of the structures that make up housing 12 may be formed from metal elements.

Device 10 may include control circuitry 14. Control circuitry 14 may include storage such as storage circuitry 16. Storage circuitry 16 may include hard disk drive storage, nonvolatile memory (e.g., flash memory or other electrically-programmable-read-only memory configured to form a solid-state drive), volatile memory (e.g., static or dynamic random-access-memory), etc. Storage circuitry 16 may include storage that is integrated within device 10 and/or removable storage media.

Control circuitry 14 may include processing circuitry such as processing circuitry 18. Processing circuitry 18 may be used to control the operation of device 10. Processing circuitry 18 may include on one or more microprocessors, microcontrollers, digital signal processors, host processors, baseband processor integrated circuits, application specific integrated circuits, central processing units (CPUs), etc. Control circuitry 14 may be configured to perform operations in device 10 using hardware (e.g., dedicated hardware or circuitry), firmware, and/or software. Software code for performing operations in device 10 may be stored on storage circuitry 16 (e.g., storage circuitry 16 may include non-transitory (tangible) computer readable storage media that stores the software code). The software code may sometimes be referred to as program instructions, software, data, instructions, or code. Software code stored on storage circuitry 16 may be executed by processing circuitry 18.

Control circuitry 14 may be used to run software on device 10 such as satellite navigation applications, internet browsing applications, voice-over-internet-protocol (VOIP) telephone call applications, email applications, media playback applications, operating system functions, etc. To support interactions with external equipment, control circuitry 14 may be used in implementing communications protocols. Communications protocols that may be implemented using control circuitry 14 include internet protocols, wireless local area network (WLAN) protocols (e.g., IEEE 802.11 protocols - sometimes referred to as Wi-Fi^{®}), protocols for other short-range wireless communications links such as the Bluetooth^{®} protocol or other wireless personal area network (WPAN) protocols, IEEE 802.11ad protocols (e.g., ultra-wideband protocols), cellular telephone protocols (e.g., 3G protocols, 4G (LTE) protocols, 5G protocols, etc.), antenna diversity protocols, satellite navigation system protocols (e.g., global positioning system (GPS) protocols, global navigation satellite system (GLONASS) protocols, etc.), antenna-based spatial ranging protocols (e.g., radio detection and ranging (RADAR) protocols or other desired range detection protocols for signals conveyed at millimeter and centimeter wave frequencies), or any other desired communications protocols. Each communications protocol may be associated with a corresponding radio access technology (RAT) that specifies the physical connection methodology used in implementing the protocol.

Device 10 may include input-output circuitry 20. Input-output circuitry 20 may include input-output devices 22. Input-output devices 22 may be used to allow data to be supplied to device 10 and to allow data to be provided from device 10 to external devices. Input-output devices 22 may include user interface devices, data port devices, and other input-output components. For example, input-output devices 22 may include touch sensors, displays (e.g., touch-sensitive and/or force-sensitive displays), light-emitting components such as displays without touch sensor capabilities, buttons (mechanical, capacitive, optical, etc.), scrolling wheels, touch pads, key pads, keyboards, microphones, cameras, buttons, speakers, status indicators, audio jacks and other audio port components, digital data port devices, motion sensors (accelerometers, gyroscopes, and/or compasses that detect motion), capacitance sensors, proximity sensors, magnetic sensors, force sensors (e.g., force sensors coupled to a display to detect pressure applied to the display), etc. In some configurations, keyboards, headphones, displays, pointing devices such as trackpads, mice, and joysticks, and other input-output devices may be coupled to device 10 using wired or wireless connections (e.g., some of input-output devices 22 may be peripherals that are coupled to a main processing unit or other portion of device 10 via a wired or wireless link).

Input-output circuitry 20 may include wireless circuitry 24 to support wireless communications. Wireless circuitry 24 (sometimes referred to herein as wireless communications circuitry 24) may include one or more antennas. Wireless circuitry 24 may also include baseband processor circuitry, transceiver circuitry, amplifier circuitry, filter circuitry, switching circuitry, radio-frequency transmission lines, and/or any other circuitry for transmitting and/or receiving radio-frequency signals using the antenna(s).

Wireless circuitry 24 may transmit and/or receive radio-frequency signals within a corresponding frequency band at radio frequencies (sometimes referred to herein as a communications band or simply as a "band"). The frequency bands handled by wireless circuitry 24 may include wireless local area network (WLAN) frequency bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network (WPAN) frequency bands such as the 2.4 GHz Bluetooth^{®} band or other WPAN communications bands, cellular telephone frequency bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, etc.), other centimeter or millimeter wave frequency bands between 10-300 GHz, near-field communications frequency bands (e.g., at 13.56 MHz), satellite navigation frequency bands (e.g., a GPS band from 1565 to 1610 MHz, a Global Navigation Satellite System (GLONASS) band, a BeiDou Navigation Satellite System (BDS) band, etc.), ultra-wideband (UWB) frequency bands that operate under the IEEE 802.15.4 protocol and/or other ultra-wideband communications protocols, communications bands under the family of 3GPP wireless communications standards, communications bands under the IEEE 802.XX family of standards, and/or any other desired frequency bands of interest.

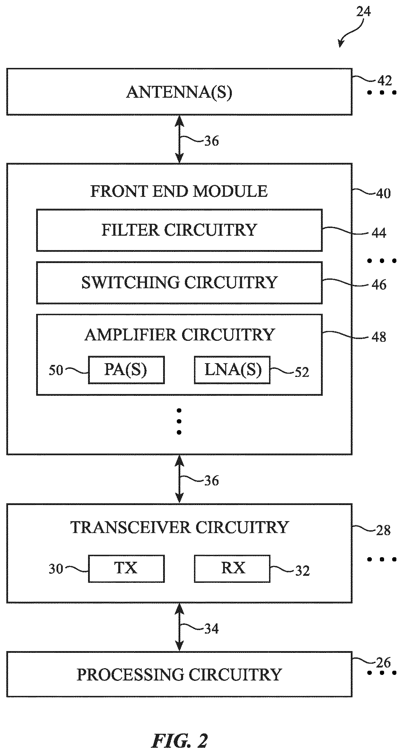

FIG. 2 is a diagram showing illustrative components within wireless circuitry 24 that can be provided with multiple amplifier control loops. As shown in FIG. 2, wireless circuitry 24 may include processing circuitry such as processing circuitry 26, radio-frequency (RF) transceiver circuitry such as radio-frequency transceiver 28, radio-frequency front end circuitry such as radio-frequency front end module (FEM) 40, and antenna(s) 42. Processing circuitry 26 may be a baseband processor, application processor, general purpose processor, microprocessor, microcontroller, digital signal processor, host processor, application specific signal processing hardware, or other type of processor. Processing circuit 26 may be coupled to transceiver 28 over path 34. Transceiver 28 may be coupled to antenna 42 via radio-frequency transmission line path 36. Radio-frequency front end module 40 may be disposed on radio-frequency transmission line path 36 between transceiver 28 and antenna 42.

In the example of FIG. 2, wireless circuitry 24 is illustrated as including only a single processing unit 26, a single transceiver 28, a single front end module 40, and a single antenna 42 for the sake of clarity. In general, wireless circuitry 24 may include any desired number of processing units 26, any desired number of transceivers 28, any desired number of front end modules 40, and any desired number of antennas 42. Each processing unit 26 may be coupled to one or more transceiver 28 over respective paths 34. Each transceiver 28 may include a transmitter circuit 30 configured to output uplink signals to antenna 42, may include a receiver circuit 32 configured to receive downlink signals from antenna 42, and may be coupled to one or more antennas 42 over respective radio-frequency transmission line paths 36. Each radio-frequency transmission line path 36 may have a respective front end module 40 disposed thereon. If desired, two or more front end modules 40 may be disposed on the same radio-frequency transmission line path 36. If desired, one or more of the radio-frequency transmission line paths 36 in wireless circuitry 24 may be implemented without any front end module disposed thereon.

Radio-frequency transmission line path 36 may be coupled to an antenna feed on antenna 42. The antenna feed may, for example, include a positive antenna feed terminal and a ground antenna feed terminal. Radio-frequency transmission line path 36 may have a positive transmission line signal path such that is coupled to the positive antenna feed terminal on antenna 42. Radio-frequency transmission line path 36 may have a ground transmission line signal path that is coupled to the ground antenna feed terminal on antenna 42. This example is merely illustrative and, in general, antennas 42 may be fed using any desired antenna feeding scheme. If desired, antenna 42 may have multiple antenna feeds that are coupled to one or more radio-frequency transmission line paths 36.

Radio-frequency transmission line path 36 may include transmission lines that are used to route radio-frequency antenna signals within device 10 (FIG. 1). Transmission lines in device 10 may include coaxial cables, microstrip transmission lines, stripline transmission lines, edge-coupled microstrip transmission lines, edge-coupled stripline transmission lines, transmission lines formed from combinations of transmission lines of these types, etc. Transmission lines in device 10 such as transmission lines in radio-frequency transmission line path 36 may be integrated into rigid and/or flexible printed circuit boards.

In performing wireless transmission, processing circuitry 26 may provide transmit signals (e.g., digital or baseband signals) to transceiver 28 over path 34. Transceiver 28 may further include circuitry for converting the transmit (baseband) signals received from processing circuitry 26 configured to generate a current that at least partially cancels a non-linear current associated with the input transistor into corresponding radio-frequency signals. For example, transceiver circuitry 28 may include mixer circuitry for up-converting (or modulating) the transmit (baseband) signals to radio frequencies prior to transmission over antenna 42. The example of FIG. 2 in which processing circuitry 26 communicates with transceiver 28 is merely illustrative. In general, transceiver 28 may communicate with a baseband processor, an application processor, general purpose processor, a microcontroller, a microprocessor, or one or more processors within circuitry 18. Transceiver circuitry 28 may also include digital-to-analog converter (DAC) and/or analog-to-digital converter (ADC) circuitry for converting signals between digital and analog domains. Transceiver 28 may use transmitter (TX) 30 to transmit the radio-frequency signals over antenna 42 via radio-frequency transmission line path 36 and front end module 40. Antenna 42 may transmit the radio-frequency signals to external wireless equipment by radiating the radio-frequency signals into free space.

In performing wireless reception, antenna 42 may receive radio-frequency signals from the external wireless equipment. The received radio-frequency signals may be conveyed to transceiver 28 via radio-frequency transmission line path 36 and front end module 40. Transceiver 28 may include circuitry such as receiver (RX) 32 for receiving signals from front end module 40 and for converting the received radio-frequency signals into corresponding baseband signals. For example, transceiver 28 may include mixer circuitry for down-converting (or demodulating) the received radio-frequency signals to baseband frequencies prior to conveying the received signals to processing circuitry 26 over path 34.

Front end module (FEM) 40 may include radio-frequency front end circuitry that operates on the radio-frequency signals conveyed (transmitted and/or received) over radio-frequency transmission line path 36. FEM 40 may, for example, include front end module (FEM) components such as radio-frequency filter circuitry 44 (e.g., low pass filters, high pass filters, notch filters, band pass filters, multiplexing circuitry, duplexer circuitry, diplexer circuitry, triplexer circuitry, etc.), switching circuitry 46 (e.g., one or more radio-frequency switches), radio-frequency amplifier circuitry 48 (e.g., one or more power amplifier circuits 50 and/or one or more low-noise amplifier circuits 52), impedance matching circuitry (e.g., circuitry that helps to match the impedance of antenna 42 to the impedance of radio-frequency transmission line 36), antenna tuning circuitry (e.g., networks of capacitors, resistors, inductors, and/or switches that adjust the frequency response of antenna 42), radio-frequency coupler circuitry, charge pump circuitry, power management circuitry, digital control and interface circuitry, and/or any other desired circuitry that operates on the radio-frequency signals transmitted and/or received by antenna 42. Each of the front end module components may be mounted to a common (shared) substrate such as a rigid printed circuit board substrate or flexible printed circuit substrate. If desired, the various front end module components may also be integrated into a single integrated circuit chip. If desired, amplifier circuitry 48 and/or other components in front end 40 such as filter circuitry 44 may also be implemented as part of transceiver circuitry 28.

Filter circuitry 44, switching circuitry 46, amplifier circuitry 48, and other circuitry may be disposed along radio-frequency transmission line path 36, may be incorporated into FEM 40, and/or may be incorporated into antenna 42 (e.g., to support antenna tuning, to support operation in desired frequency bands, etc.). These components, sometimes referred to herein as antenna tuning components, may be adjusted (e.g., using control circuitry 14) to adjust the frequency response and wireless performance of antenna 42 over time.

Transceiver 28 may be separate from front end module 40. For example, transceiver 28 may be formed on another substrate such as the main logic board of device 10, a rigid printed circuit board, or flexible printed circuit that is not a part of front end module 40. While control circuitry 14 is shown separately from wireless circuitry 24 in the example of FIG. 1 for the sake of clarity, wireless circuitry 24 may include processing circuitry that forms a part of processing circuitry 18 and/or storage circuitry that forms a part of storage circuitry 16 of control circuitry 14 (e.g., portions of control circuitry 14 may be implemented on wireless circuitry 24). As an example, processing circuitry 26 and/or portions of transceiver 28 (e.g., a host processor on transceiver 28) may form a part of control circuitry 14. Control circuitry 14 (e.g., portions of control circuitry 14 formed on processing circuitry 26, portions of control circuitry 14 formed on transceiver 28, and/or portions of control circuitry 14 that are separate from wireless circuitry 24) may provide control signals (e.g., over one or more control paths in device 10) that control the operation of front end module 40.

Transceiver circuitry 28 may include wireless local area network transceiver circuitry that handles WLAN communications bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network transceiver circuitry that handles the 2.4 GHz Bluetooth^{®} band or other WPAN communications bands, cellular telephone transceiver circuitry that handles cellular telephone bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, etc.), 6G bands between 100-1000 GHz (e.g., sub-THz , THz, or THF bands, etc.), near-field communications (NFC) transceiver circuitry that handles near-field communications bands (e.g., at 13.56 MHz), satellite navigation receiver circuitry that handles satellite navigation bands (e.g., a GPS band from 1565 to 1610 MHz, a Global Navigation Satellite System (GLONASS) band, a BeiDou Navigation Satellite System (BDS) band, etc.), ultra-wideband (UWB) transceiver circuitry that handles communications using the IEEE 802.15.4 protocol and/or other ultra-wideband communications protocols, and/or any other desired radio-frequency transceiver circuitry for covering any other desired communications bands of interest.

Wireless circuitry 24 may include one or more antennas such as antenna 42. Antenna 42 may be formed using any desired antenna structures. For example, antenna 42 may be an antenna with a resonating element that is formed from loop antenna structures, patch antenna structures, inverted-F antenna structures, slot antenna structures, planar inverted-F antenna structures, helical antenna structures, monopole antennas, dipoles, hybrids of these designs, etc. Two or more antennas 42 may be arranged into one or more phased antenna arrays (e.g., for conveying radio-frequency signals at millimeter wave frequencies). Parasitic elements may be included in antenna 42 to adjust antenna performance. Antenna 42 may be provided with a conductive cavity that backs the antenna resonating element of antenna 42 (e.g., antenna 42 may be a cavity-backed antenna such as a cavity-backed slot antenna).

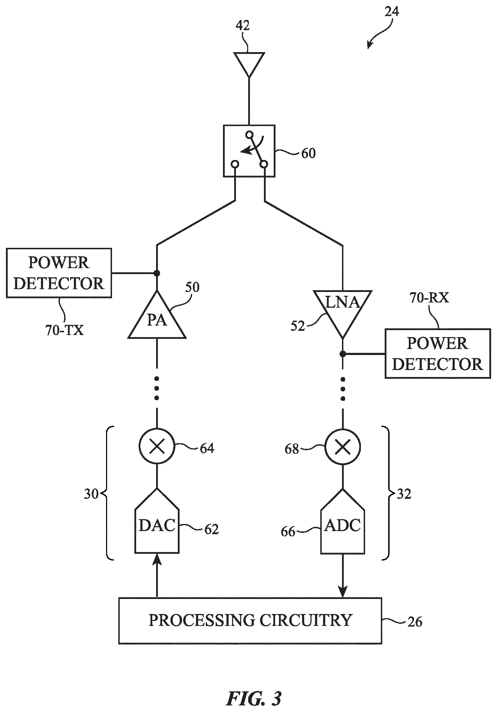

Radio-frequency amplifiers may be coupled to power detectors for power monitoring purposes. FIG. 3 is a diagram showing illustrative power detectors coupled to radio-frequency amplifier outputs. As shown in FIG. 3, wireless circuitry 24 can have one or more antenna 42 that is coupled to a transmit path and a receive path via a radio-frequency duplexing circuit such as duplexer 60. Duplexer 60 may have a first port coupled to a shared antenna 42, a second port coupled to the transmit path (e.g., a second port configured to receive amplified radio-frequency signals to be radiated by antenna 42), and a third port coupled to the receive path (e.g., a third port to which radio-frequency signals received by antenna 42 are conveyed).

The receive path can include low noise amplifier (LNA) circuitry 52, a downconverting mixing circuit such as mixer 68, and a data converter such as analog-to-digital converter (ADC) 66. The LNA circuitry 52 can include one or more amplifiers coupled in series and/or in parallel. Mixer 68 may use a local oscillator signal to downconvert (or demodulate) the radio-frequency signals to baseband (or intermediate) frequencies. Analog-to-digital converter (ADC) circuit 66 can then convert the demodulated signals from the analog domain to the digital domain to generate corresponding digital baseband signals. Mixer 68 and ADC circuit 66 are sometimes be considered part of receiver circuitry 32. The digital baseband signals can then be received by one or more processing units 26. Processing circuitry 26 may represent one or more processors such as a baseband processor, an application processor, a digital signal processor, a microcontroller, a microprocessor, a central processing unit (CPU), a programmable device, a combination of these circuits, and/or one or more processors within circuitry 18 (see FIG. 1).

The circuitry described above for processing signals received by antenna 42 is sometimes referred to collectively as wireless receiving circuitry. If desired, one or more additional front end module components such as radio-frequency filter circuitry 44 of FIG. 2 (e.g., low pass filters, high pass filters, notch filters, band pass filters, multiplexing circuitry, duplexer circuitry, diplexer circuitry, triplexer circuitry, etc.), switching circuitry 46 (e.g., one or more radio-frequency switches), impedance matching circuitry, antenna tuning circuitry (e.g., networks of capacitors, resistors, inductors, and/or switches that adjust the frequency response of antenna 42), radio-frequency coupler circuitry, charge pump circuitry, power management circuitry, and/or any other desired front-end module circuitry can optionally be coupled at the input and/or output of LNA circuitry 52 along the radio-frequency reception line path.

On the other hand, the transmit path can include power amplifier (PA) circuitry 50, a upconverting mixing circuit such as mixer 64, and a data converter such as digital-to-analog converter (DAC) 62. Processing circuitry 26 can generate digital baseband signals, sometimes referred to as digital signals for transmission. DAC circuit 62 can convert the digital baseband signals from the digital domain to the analog domain to generate corresponding analog baseband signals. Mixer 64 may use a local oscillator signal to upconvert (or modulate) the radio-frequency signals to radio (or intermediate) frequencies. DAC circuit 62 and mixer 64 are sometimes be considered part of transmitter circuitry 30. The upconverted radio-frequency signals can then be fed to amplifier circuitry 50. The PA circuitry 52 can include one or more amplifiers coupled in series and/or in parallel that are configured to amplify signals for transmission by antenna 42.

The circuitry described above for preparing signals for transmission by antenna 42 is sometimes referred to collectively as wireless transmitting circuitry. If desired, one or more additional front end module components such as radio-frequency filter circuitry 44 of FIG. 2 (e.g., low pass filters, high pass filters, notch filters, band pass filters, multiplexing circuitry, duplexer circuitry, diplexer circuitry, triplexer circuitry, etc.), switching circuitry 46 (e.g., one or more radio-frequency switches), impedance matching circuitry, antenna tuning circuitry (e.g., networks of capacitors, resistors, inductors, and/or switches that adjust the frequency response of antenna 42), radio-frequency coupler circuitry, charge pump circuitry, power management circuitry, and/or any other desired front-end module circuitry can optionally be coupled at the input and/or output of amplifier circuitry 50 along the radio-frequency transmission line path.

Power detection circuits can be coupled to the outputs of the radio-frequency amplifiers to enable power monitoring operations. Still referring to FIG. 3, a first power detection circuit such as power detector 70-TX may be coupled to the output of transmitting amplifier circuitry 50, whereas a second power detection circuit such as power detector 70-RX may be coupled to the output of receiving amplifier circuitry 52. Power detector 70-TX can be used to detect or measure an output power level of radio-frequency signals generated at the output of amplifier circuitry 50. The detected output power level can then be used by an automatic power control (APC) algorithm to dynamically adjust the gain of power amplifier circuitry 50 to ensure that the transmit path is outputting signals at desired power levels. The APC algorithm, which can run on processing circuitry 26 or other control circuitry in device 10, can compare the measured output power level to a reference power level. If the output power level is too high, the APC algorithm can reduce the gain of amplifier 50. If the output power level is too low, the APC algorithm can increase the gain of amplifier 50.

Power detector 70-RX can be used to detect or measure an output power level of radio-frequency signals generated at the output of receiving amplifier circuitry 52. The detected output power level can then be used by an automatic gain control (AGC) algorithm to dynamically adjust the gain of LNA circuitry 52 to ensure that the receive path is outputting signals at desired power levels regardless of the strength of signals arriving at the input of circuitry 52. The AGC algorithm, which can run on processing circuitry 26 or other control circuitry in device 10, can be used to ensure that signals are output from circuitry 52 at a constant output power level. If the input signal is weak, the AGC algorithm can increase the gain of amplifier 52 to maintain constant output level. If the input signal is strong, then the AGC algorithm can reduce the gain of amplifier 52 to prevent the output level from becoming too high.

The configuration of FIG. 3 in which transmit path and the receive path share a common antenna 42 via duplexer 60 is illustrative. The present embodiments are not limited to a time-division duplexing system where the transmit and receive paths share the same antenna. In other embodiments, a transmit path including power amplifier 50 can be coupled to a first antenna, whereas a receive path including low noise amplifier 52 can be coupled to a second antenna separate from the first antenna. In such scenarios, power detector 70-TX can be coupled to the output of power amplifier 50 while power detector 70-RX can be coupled to the output of low noise amplifier 52.

In certain wireless applications, a radio-frequency amplifier can be configured to receive a bias setting (e.g., a bias voltage such as a power supply voltage) that changes depending on the current modulation scheme. For example, wireless circuitry 24 of the type described in connection with FIGS. 1-3 can be configured to support orthogonal frequency-division multiplexing (OFDM) modulation schemes, including but not limited to binary phase shift keying (BPSK), quadrature phase shift keying (QPSK), 16-quadrature amplitude modulation (16-QAM), 32-quadrature amplitude modulation (32-QAM), 64-quadature amplitude modulation (64-QAM), 128-quadrature amplitude modulation (128-QAM), 256-quadrature amplitude modulation (256-QAM), 512-quadrature amplitude modulation (512-QAM), 1024-quadrature amplitude modulation (1024-QAM), and/or other wireless modulation schemes. Each modulation scheme can exhibit a different signal modulation quality that is measured using a metric known as error vector magnitude (EVM). EVM is a metric for quantifying the performance of a transmitted signal by comparing a received signal with an ideal or reference signal in a complex plane. A lower EVM indicates a better signal quality, whereas a higher EVM indicates a poorer signal quality.

In general, lower modulation schemes such as QPSK require higher signal power level but can tolerate higher EVM (i.e., lower signal quality), whereas higher modulation schemes such as 64-QAM or 256-QAM require a lower EVM (i.e., higher signal quality) but can also tolerate a lower signal power level. Certain wireless standards may also require device 10 to support changing modulation schemes during OFDM symbol transitions within a slot. In other words, the EVM requirement can vary from symbol to symbol with changing modulation schemes. Thus, in order to optimize device 10 for minimum power consumption with satisfactory EVM per modulation, it may be desirable to adjust a bias setting for the radio-frequency amplifier. This example in which a different amplifier bias setting can be employed for each wireless modulation scheme is illustrative.

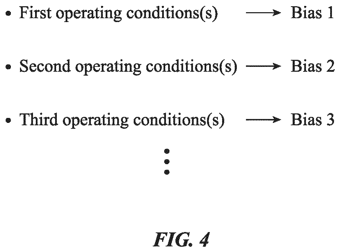

In general, different amplifier bias settings can be used for different operating conditions in accordance with some embodiments (see, e.g., FIG. 4). As shown in FIG. 4, a radio-frequency amplifier of wireless circuitry 24 can be configured to operate using a first bias setting Bias1 in response to detecting a first set of operating conditions, a second bias setting Bias2 in response to detecting a second set of operating conditions different than the first set of operating conditions, a third bias setting Bias3 in response to detecting a third set of operating conditions different than the first and second sets of operating conditions, and so on. The various bias settings (e.g., Bias1, Bias2, Bias3, etc.) can correspond to different positive power supply voltage levels, different ground power supply voltage levels, different transistor bias voltage levels, different bias current levels, and/or other bias settings for a radio-frequency amplifier. The bias settings can thus be referred to amplifier bias settings. The various operating conditions can correspond to different wireless/radio-frequency modulation schemes (standards), operating power levels (e.g., ranges of power levels), scenarios with different bandwidths, scenarios with different resource block allocations, scenarios with different adjacent channel leakage ratio (ACLR) requirements, scenarios in which digital predistortion is selectively activated or deactivated, etc.

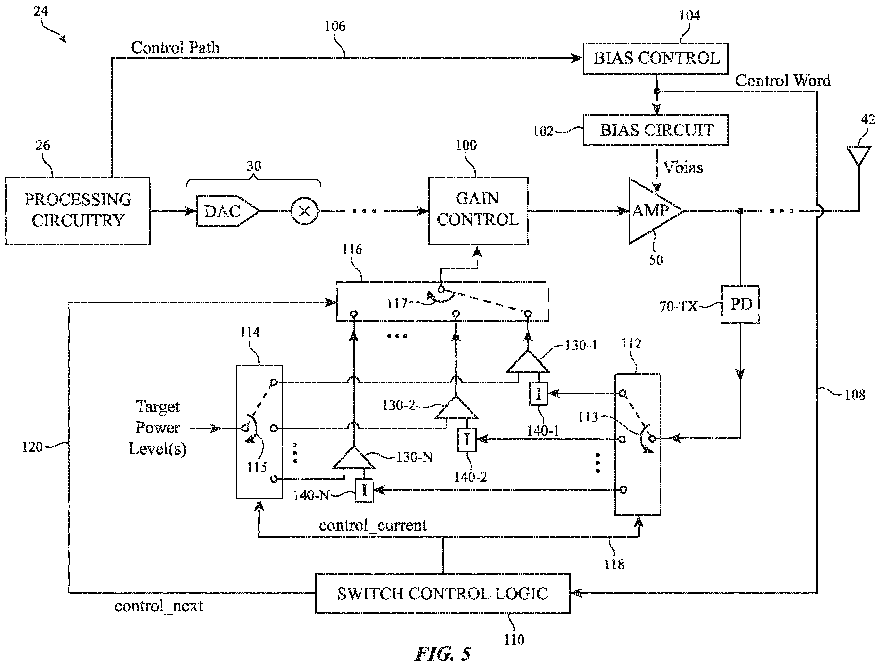

FIG. 5 is a diagram of illustrative wireless circuitry 24 having radio-frequency amplifier 50 that is coupled to a plurality of control loops corresponding to different bias settings. In other words, each bias setting can be provided with a separate power control loop. As shown in FIG. 5, processing circuitry 26 may be coupled to radio-frequency amplifier 50 via a radio-frequency data path. The processing circuitry 26 can be configured to generate digital signals, which are sometimes referred to as baseband signals, digital signals, digital baseband signals, or transmit signals. As examples, the digital signals generated by processor 26 may include in-phase (I) and quadrature-phase (Q) signals, radius and phase signals, or other digitally-coded signals. The radio-frequency data path, sometimes referred to as a transmit path, can include a transmit circuit 30 having one or more data converters (e.g., digital-to-analog converters or DACs) and one or more mixers (e.g., upconversion or modulator circuits for upconverting signals from a baseband frequency range in the range of a couple hundred to a couple thousand Hz to radio frequencies in the range of hundreds of MHz, in the GHz range, or in the THz range).

The transmit path can also include one or more gain control stages such as gain control circuit 100 coupled to the input of radio-frequency amplifier 50. Gain control circuit 100 can represent one or more passive attenuation circuits, one or more active gain circuits, one or more variable gain amplifiers (VGAs), one or more gain stages, and/or other types of signal attenuation/amplification circuit(s). If desired, the transmit path can further include a digital predistortion circuit (e.g., a circuit for predistorting baseband signals prior to the digital-to-analog conversion stage) and/or other baseband/intermediate-frequency/radio-frequency transmitting circuit components.

Radio-frequency amplifier 50 may have an output that is coupled to antenna 42. Although not explicitly shown in FIG. 5, one or more additional radio-frequency front end components (e.g., filter, switching, tuning, or matching circuitry) can be coupled to the input or output of amplifier 50. Radio-frequency amplifier 50, sometimes referred to as a transmit amplifier or a power amplifier, can receive one or more bias voltages Vbias from a bias circuit 102. Bias voltage Vbias can represent a positive power supply voltage, a ground power supply voltage, an intermediate power supply voltage (e.g., a voltage between the positive power supply voltage and the ground power supply voltage), and/or other dynamically adjustable bias voltage that can be provided to amplifier 50. Bias circuit 102 can represent one or more bandgap reference circuit, low dropout regulator (LDO) circuit, voltage reference circuit, current mirror, and/or other types of voltage or current generation circuits.

Bias circuit 102 may produce bias voltage(s) Vbias with an adjustable voltage level based on a value of a control word output from bias controller 104. Bias controller 104 may receive control signals from processing circuitry 26 via control path 106 and may output a corresponding control word at its output. The control word output by bias controller 104 may be a digital control word. The control signals received by bias controller 104 may be indicative of different operating conditions for amplifier 50. For example, if processing circuitry 26 outputs first control signals indicative of a first set of operating conditions for amplifier 50, then bias controller 104 would output a first control word directing bias circuit 102 to provide a first bias setting (or voltage/current settings) to amplifier 50. If processing circuitry 26 outputs second control signals indicative of a second set of operating conditions for amplifier 50, then bias controller 104 would output a second control word directing bias circuit 102 to provide a second bias setting (or voltage/current settings) to amplifier 50. If processing circuitry 26 outputs third control signals indicative of a third set of operating conditions for amplifier 50, then bias controller 104 would output a third control word directing bias circuit 102 to provide a third bias setting (or voltage/current settings) to amplifier 50. In other words, bias controller 104 can output different digital control words corresponding to the different operating conditions described in connection with FIG. 4. This is illustrative. In general, bias controller 104 and bias circuit 102 can be configured to provide two or more bias settings, three or more bias settings, four to ten bias settings, or more than ten different bias settings to amplifier 50.

A power detector such as power detector 70-TX can be couple to the output of radio-frequency amplifier 50. Power detector 70-TX can be configured to output a detected or measured output power level of amplifier 50. Conventionally, a power detector is connected to a single power control loop. A single power control loop might be adequate for tracking slow gain changes due to temperature and supply voltage drifts on the order of hundreds of milliseconds. A single power control loop, however, cannot converge to desired power levels when the gain requirement changes in accordance with the symbol rate, which can be on the order of microseconds. In other words, the symbol rate might be too fast to be handled by a single power control loop.

In accordance with an embodiment, power detector 70-TX can be coupled to multiple power control loops. Each control loop in the plurality of power control loops corresponds to a different amplifier bias setting. In the example of FIG. 5, power detector 70-TX can convey the measured output power level to a switching circuit such as switch 112. Switch 112 may have an input coupled to power detector 70-TX, a first output coupled to a first power integrator 140-1, a second output coupled to a second power integrator 140-2, ... , and an N^{th} output coupled to an N^{th} power integrator 140-N. In general, N can represent an integer equal to 2, 3, 4, 5, 6, 7, 8, 9, 10, greater than 10, some power of two, or other integer value. As an example, each power integrator 140 can be dedicated to accumulating power samples for a corresponding modulation scheme, so each power integrator 140 may include historical (memory) information.

Each power integrator 140 can be coupled to a corresponding comparator 130. For example, the first power integrator 140-1 can be coupled to a first input of comparator 130-1, the second power integrator 140-2 can be coupled to a first input of comparator 130-2, . . . , and the N^{th} power integrator 140-N can be coupled to a first input of comparator 130-N. The comparators 130 can each have a second input configured to receive a corresponding target power level from switching circuit 114. Switch 114 may have an input configured to receive one or more target power level(s), a first output coupled to the second input of comparator 130-1, a second output coupled to the second input of comparator 130-2, . . . , and an N^{th} output coupled to the second input of comparator 130-N.

Configured in this way, each comparator 130 can receive an integrated power level at its first input, a target (expected) power level at its second input, and can produce a corresponding power correction (error) signal at its output. In particular, comparator 130-1 can receive an integrated power level from integrator 140-1 and a first target power level from switch 114 and then produce a first power correction signal at its output; comparator 130-2 can receive an integrated power level from integrator 140-2 and a second target power level from switch 114 and then produce a second power correction signal at its output; . . . ; and comparator 130-N can receive an integrated power level from integrator 140-N and an N^{th} target power level from switch 114 and then produce an N^{th} power correction signal at its output.

The power correction signals, sometimes also referred to as power "error" signals, can be received at an output switching circuit such as switch 116. Switch 116 may have a first input configured to receive the first power error signal from comparator 130-1, a second input configured to receive the second power error signal from comparator 130-2, ... , an N^{th} input configured to receive the N^{th} power error signal from comparator 130-N, and an output coupled to a control input of gain control circuit 100. Gain control circuit 100 can attenuate or amplify signals that are being fed to amplifier 50 by an amount proportional to the received power error signal.

Switches 112, 114, and 116 can be controlled by a switch controller such as switch control logic 110. Switch control logic 110 can receive the digital control word output from bias controller 104 in response to the control signals received via control path 106. Switch control logic 110 may control switches 112 and 114 in accordance with the current bias setting (e.g., by sending control signals control_current to switches 112 and 114 via switch control path 118). Control signals control_current may simultaneously control the state of switch 112 (e.g., by changing the state of switch 112, as shown by arrow 113) and the state of switch 114 (e.g., by changing the state of switch 114, as shown by arrow 115). When the power measured by the power detector is being directed towards the first comparator 130-1 via the first power integrator 140-1 coupled to the first output of switch 112, then switch 114 should also feed a corresponding target power level to comparator 130-1. When the power measured by the power detector is being directed towards the second comparator 130-2 via the second power integrator 140-2 coupled to the second output of switch 112, then switch 114 should also feed a corresponding target power level to comparator 130-2, and so on.

At the output end, switch control logic 110 may control switch 116 in accordance with the next bias setting (e.g., by sending control signals control_next to switch 116 via switch control path 120). In other words, switch control logic 110 may control the output switch 116 (e.g., by changing the state of switch 116, as shown by arrow 117) in accordance with a future bias setting. Control signals control_current and control_next can each be at least partially determined by the digital control word output from bias controller 104. The power correction being applied to gain control circuit 110 via switch 116 is thus being applied to future OFDM symbols that will be using an upcoming amplifier bias setting. The example of FIG. 5 thus includes N power control loops. The first control loop can include power integrator 140-1, comparator 130-1, and a first target power level associated with the first control loop (e.g., associated with the first bias setting). The second control loop can include power integrator 140-2, comparator 130-2, and a second target power level associated with the second control loop (e.g., associated with the second bias setting). Similarly, the N^{th} control loop can include power integrator 140-N, comparator 130-N, and an N^{th} target power level associated with the N^{th} control loop (e.g., associated with the N^{th} bias setting). Power detector 70-TX and switches 112, 114, and 116 can be considered to be shared among the N power control loops.

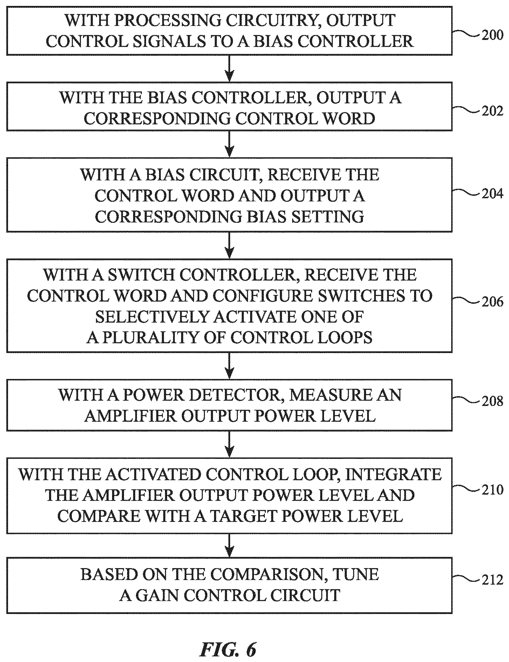

FIG. 6 is flowchart of illustrative steps for operating wireless circuitry 24 of the type described in connection with FIG. 5. During the operations of block 200, processing circuitry 26 can be configured to output control signals to bias controller 104. The control signals can have different values corresponding to different operating conditions associated with radio-frequency amplifier 50.

During the operations of block 202, bias controller 104 can output a corresponding control word. For example, bias controller 104 can output a digital control word based on the control signals received via path 106. Different control signals can result in different control words. In other words, different control words can be associated with different amplifier operating conditions.

During the operations of block 204, bias circuit 102 can receive the digital control word output from bias controller 104 and subsequently output a corresponding bias setting for radio-frequency amplifier 50. For example, a first digital control word output from bias controller 104 may direct bias circuit 102 to produce a first bias voltage Vbias1 for amplifier 50. As another example, a second digital control word output from bias controller 104 may direct bias circuit 102 to produce a second bias voltage Vbias2 for amplifier 50. As another example, a third digital control word output from bias controller 104 may direct bias circuit 102 to produce a third bias voltage Vbias2 for amplifier 50, etc.

During the operations of block 206, switch controller 110 can receive the digital control word output from bias controller 104 and subsequently configure switches 112, 114, and 116 to selectively activate one of the N power control loops. For example, the first digital control word output from bias controller 104 can result in switch controller 110 activating a first of the N control loops. As another example, the second digital control word output from bias controller 104 can result in switch controller 110 activating a second of the N control loops. As another example, the third digital control word output from bias controller 104 can result in switch controller 110 activating a third of the N control loops.

During the operations of block 208, power detector 70-TX can be configured to measure an output power level of radio-frequency amplifier 50. Power detector 70-TX may convey the measured amplifier output power level to switch 112. Switch 112 can then pass the measured amplifier output power level to a selected one of the N power integrators 140 depending on the state of switch. Switch controller 110 may control switch 112 according to the current bias setting for amplifier 50.

During the operations of block 210, the power integrator 140 in the activated power control loop can integrate the received measured amplifier output power level to produce an integrated power level. An associated comparator 130 in the activated power control loop can then compare the integrated power level with a target power level received via switch 114. Switch controller 110 may control switch 114 according to the current bias setting for amplifier 50. The various target power levels associated with the different amplifier bias settings can be equal or can be the same.

During the operations of block 212, the comparator 130 in the activated power control loop can output a power correction (error) signal to gain control circuit 100 via switch 116. Switch controller 110 may control switch 116 according to the next (subsequent) bias setting for amplifier 50. The activated power control loop can thus dynamically adjust gain control circuit 100 to attenuate or amplifier the signals arriving at amplifier 50 to minimize the power correction/error signal (e.g., so that the measured amplifier output power level will more accurately match the target power level). Configuring wireless circuitry 24 with multiple power control loops is thus technically advantageous and beneficial for operating amplifier 50 under different bias settings that can change between successive OFDM symbols while accurately tracking the desired output power levels.

The operations of FIG. 6 are illustrative. In some embodiments, one or more of the described operations may be modified, replaced, or omitted. In some embodiments, one or more of the described operations may be performed in parallel. In some embodiments, additional processes may be added or inserted between the described operations. If desired, the order of certain operations may be reversed or altered and/or the timing of the described operations may be adjusted so that they occur at slightly different times. In some embodiments, the described operations may be distributed in a larger system.

The examples described in connection with FIGS. 4-6 in which the multiple power control loops are selectively activated based on a bias setting associated with the radio-frequency amplifier are illustrative. In general, the multiple control loops can be selectively switched into use based on a mode setting (e.g., a transmit operation modes setting), a configuration setting (e.g., a transmit configuration setting), an operating condition setting (e.g., a transmit operation condition setting), and/or other operational setting associated with the radio-frequency amplifier or one or more transmit circuits along the transmit signal path that can impact the gain or gain variation behavior in the transmit path. In such arrangements, the output of the selected power control loop (e.g., the output of switch 116) can be used to adjust one or more gain/attenuation stages along the transmit signal chain.

Thus, the bias controller 104 in FIG. 5 can be more generically referred to as a mode controller (e.g., a transmit operation modes controller), a configuration controller (e.g., a transmit configuration controller), an operating condition controller (e.g., a transmit operation condition controller), and/or other controller configured to output a control word that determines an operational setting associated with the radio-frequency amplifier or other transmit circuits/components along the transmit chain. The transmit mode, configuration, or operational setting can be conveyed from processing circuitry 26 to controller 104 in the example of FIG. 5. Referring back to FIG. 4, different operating conditions can not only result in different amplifier bias settings but can additionally or alternatively result in different transmit operation modes settings, different transmit configuration settings, different transmit operation condition settings, etc.

As an example, in accordance with another embodiment, instead of tuning the bias setting for the power amplifier, one or more amplification stages along the transmit path can be adjusted with a different gain per stage such that the sum of all stages provides the target gain but the power consumption or non-linearity distortion between the various settings is different and is separately optimized for the specific signal or modulation that is about to be transmitted.

The methods and operations described above in connection with FIGS. 1-6 may be performed by the components of device 10 using software, firmware, and/or hardware (e.g., dedicated circuitry or hardware). Software code for performing these operations may be stored on non-transitory computer readable storage media (e.g., tangible computer readable storage media) stored on one or more of the components of device 10 (e.g., storage circuitry 16 and/or wireless communications circuitry 24 of FIG. 1). The software code may sometimes be referred to as software, data, instructions, program instructions, or code. The non-transitory computer readable storage media may include drives, non-volatile memory such as non-volatile random-access memory (NVRAM), removable flash drives or other removable media, other types of random-access memory, etc. Software stored on the non-transitory computer readable storage media may be executed by processing circuitry on one or more of the components of device 10 (e.g., processing circuitry in wireless circuitry 24, processing circuitry 18 of FIG. 1, etc.). The processing circuitry may include microprocessors, application processors, digital signal processors, central processing units (CPUs), application-specific integrated circuits with processing circuitry, or other processing circuitry.

In accordance with an aspect of the invention, wireless circuitry includes one or more transmit circuits operable using a plurality of different mode settings, a power detection circuit coupled to an output the one or more transmit circuits, a plurality of power integrators, and a first switching circuit having an input configured to receive a measured power level from the power detection circuit and having outputs coupled to the plurality of power integrators, where the first switching circuit has a switch state that is adjusted based on a current mode setting in the plurality of different mode settings for the one or more transmit circuits.

Preferably, the wireless circuitry optionally includes a mode controller configured to output a control word, where the control word determines the current mode setting for the one or more transmit circuits, and a switch controller configured to receive the control word from the mode controller and adjust the switch state of the first switching circuit.

Preferably, the plurality of power integrators optionally includes a first power integrator having an input coupled to the first switching circuit and configured to produce a first integrated power level, and a second power integrator optionally having an input coupled to the first switching circuit and configured to produce a second integrated power level.

Preferably, the wireless circuitry optionally includes a first comparator having a first input configured to receive the first integrated power level from the first power integrator, and a second comparator optionally having a first input configured to receive the second integrated power level from the second power integrator.

Preferably, the wireless circuitry optionally includes a second switching circuit configured to provide a first target power level to a second input of the first comparator and a second target power level to a second input of the second comparator, where the second switching circuit has a switch state that is adjusted based on the current mode setting for the radio-frequency amplifier.

Preferably, the wireless circuitry optionally includes a third switching circuit having an first input configured to receive a first power correction signal from the first comparator and a second input configured to receive a second power correction signal from the second comparator, where the third switching circuit has a switch state that is adjusted based on another mode setting, different than the current mode setting, in the plurality of different mode settings for the radio-frequency amplifier.

Preferably, the third switching circuit optionally has an output coupled to the one or more transmit circuits.

Preferably, a first mode setting in the plurality of different mode settings is optionally used when the wireless circuitry is processing signals in accordance with a first modulation scheme, and a second mode setting in the plurality of different mode settings is optionally used when the wireless circuitry is processing signals in accordance with a second modulation scheme different than the first modulation scheme.

Preferably, the first modulation scheme optionally includes quadrature phase shift keying (QPSK), and the second modulation scheme optionally includes 64-quadature amplitude modulation (64-QAM), 128-quadrature amplitude modulation (128-QAM), 256-quadrature amplitude modulation (256-QAM), 512-quadrature amplitude modulation (512-QAM), or 1024-quadrature amplitude modulation (1024-QAM).

Preferably, a first mode setting in the plurality of different mode settings is optionally used to bias a radio-frequency amplifier in the one or more transmit circuits with a first bias setting, and a second mode setting in the plurality of different mode settings is optionally used to bias the radio-frequency amplifier with a second bias setting different than the first bias setting.

In accordance with an aspect of the invention, wireless circuitry includes a radio-frequency amplifier operable using a plurality of different bias settings, a power detection circuit coupled to an output of the radio-frequency amplifier, a plurality of power integrators, and a first switching circuit having an input configured to receive a measured power level from the power detection circuit and having outputs coupled to the plurality of power integrators, where the first switching circuit has a switch state that is adjusted based on a current bias setting in the plurality of different bias settings for the radio-frequency amplifier.

Preferably, the wireless circuitry optionally includes a bias circuit configured to output one or more bias signals to the radio-frequency amplifier based on a control word that at least partially determines the current bias setting for the radio-frequency amplifier.

Preferably, the wireless circuitry optionally includes a bias controller configured to output the control word, and a switch controller configured to receive the control word from the bias controller and adjust the switch state of the first switching circuit.

Preferably, the plurality of power integrators optionally includes a first power integrator having an input coupled to the first switching circuit and configured to produce a first integrated power level, and a second power integrator having an input coupled to the first switching circuit and configured to produce a second integrated power level.

Preferably, the wireless circuitry optionally includes a first comparator having a first input configured to receive the first integrated power level from the first power integrator, and a second comparator having a first input configured to receive the second integrated power level from the second power integrator.

Preferably, the wireless circuitry optionally includes a second switching circuit configured to provide a first target power level to a second input of the first comparator and a second target power level to a second input of the second comparator, where the second switching circuit optionally has a switch state that is adjusted based on the current bias setting for the radio-frequency amplifier, and a third switching circuit optionally having an first input configured to receive a first power correction signal from the first comparator and a second input configured to receive a second power correction signal from the second comparator, the third switching circuit optionally has a switch state that is adjusted based on another bias setting, different than the current bias setting, in the plurality of different bias settings for the radio-frequency amplifier.

Preferably, the wireless circuitry optionally includes a gain control circuit coupled to an output of the third switching circuit and configured to output signals to the radio-frequency amplifier.

Preferably, a first bias setting in the plurality of different bias settings is optionally used when the wireless circuitry is processing signals in accordance with a first modulation scheme, a second bias setting in the plurality of different bias settings is optionally used when the wireless circuitry is processing signals in accordance with a second modulation scheme different than the first modulation scheme, the first modulation scheme optionally includes quadrature phase shift keying (QPSK), and the second modulation scheme optionally includes 64-quadature amplitude modulation (64-QAM), 128-quadrature amplitude modulation (128-QAM), 256-quadrature amplitude modulation (256-QAM), 512-quadrature amplitude modulation (512-QAM), or 1024-quadrature amplitude modulation (1024-QAM).

Preferably, a first bias setting in the plurality of different bias settings is optionally used when the wireless circuitry is processing signals within a first range of power levels, and a second bias setting in the plurality of different bias settings is optionally used when the wireless circuitry is processing signals within a second range of power levels different than the first range of power levels.

In accordance with an aspect of the invention, circuitry includes a signal path having one or more amplifier stages, a gain control circuit configured to attenuate or amplify signals along the signal path, a bias controller for outputting a control word that determines a configuration setting for the one or more amplifier stages, and a plurality of power control loops, where a selected power control loop in the plurality of power control loops is activated based at least partly on the control word to provide a power correction signal to the one or more amplifier stages.

In accordance with an aspect of the invention, a method of operating wireless circuitry includes operating one or more transmit circuits using a mode setting selected from among a plurality of mode settings, with a power detector, measuring a power level of the one or more transmit circuits, with a first switching circuit, conveying the measured power level from the power detector to a selected power control loop in a plurality of power control loops, and
controlling the first switching circuit based on the mode setting currently being used to operate the one or more transmit circuits.

Preferably, measuring the power level of the radio-frequency amplifier optionally includes measuring an output power level at an output of a radio-frequency amplifier in the one or more transmit circuits.

Preferably, the method optionally includes outputting a digital control word that determines the mode setting for the one or more transmit circuits with a mode controller.

Preferably, the plurality of power control loops optionally includes a first power control loop having a first power integrator coupled to the first switching circuit and a first comparator configured to receive an integrated power level from the first power integrator, and
a second power control loop having a second power integrator coupled to the first switching circuit and a second comparator configured to receive an integrated power level from the second power integrator.

Preferably, the method optionally includes selectively providing a first target power level to the first comparator or a second target power level to the second comparator with a second switching circuit.

Preferably, the method optionally includes receiving a first power error signal from the first comparator or receiving a second power error signal from the second comparator with a third switching circuit.

Preferably, the method optionally includes controlling the second switching circuit based on the mode setting currently being used to operate the one or more transmit circuits, and controlling the third switching circuit based on a subsequent mode setting, different than the current mode setting, for operating the one or more transmit circuits.

Preferably, the method optionally includes attenuating or amplifying a signal for the one or more transmit circuits based on a power error signal received from the third switching circuit.

In accordance with an aspect of the invention, a method of operating wireless circuitry includes operating a radio-frequency amplifier using a bias setting selected from among a plurality of bias settings, with a power detector, measuring a power level of the radio-frequency amplifier, with a first switching circuit, conveying the measured power level from the power detector to a selected power control loop in a plurality of power control loops, and controlling the first switching circuit based on the bias setting currently being used to operate the radio-frequency amplifier.

Preferably, measuring the power level of the radio-frequency amplifier optionally includes measuring an output power level at an output of the radio-frequency amplifier.

Preferably, the method optionally includes outputting a digital control word that determines the bias setting for the radio-frequency amplifier with a bias controller.

Preferably, the plurality of power control loops optionally includes a first power control loop having a first power integrator coupled to the first switching circuit and a first comparator configured to receive an integrated power level from the first power integrator, and a second power control loop having a second power integrator coupled to the first switching circuit and a second comparator configured to receive an integrated power level from the second power integrator.

Preferably, the method optionally includes selectively providing a first target power level to the first comparator or a second target power level to the second comparator with a second switching circuit.

Preferably, the method optionally includes receiving a first power error signal from the first comparator or receiving a second power error signal from the second comparator with a third switching circuit.

Preferably, the method optionally includes controlling the second switching circuit based on the bias setting currently being used to operate the radio-frequency amplifier, and controlling the third switching circuit based on a subsequent bias setting, different than the current bias setting, for operating the radio-frequency amplifier.

Preferably, the method optionally includes attenuating or amplifying a signal based on a power error signal received from the third switching circuit with a gain control circuit coupled to the radio-frequency amplifier.

In accordance with an aspect of the invention, circuitry includes means for operating one or more transmit circuits using a configuration setting selected from among a plurality of configuration settings, means for measuring a power level of the one or more transmit circuits, a switch for conveying the measured power level to a selected power control loop in a plurality of power control loops, and means for controlling the switch based on the configuration setting.

Preferably, each power control loop in the plurality of power control loops optionally includes means for integrating the measured power level to produce a corresponding integrated power level, and means for comparing the integrated power level with a target power level.

Preferably, the circuitry optionally includes means for coupling one of the plurality of power control loops to a gain or attenuation stage in the one or more transmit circuits.

Preferably, the circuitry optionally includes means for generating a digital code word based on the configuration setting, where the switch is controlled by the digital code word.

The foregoing is merely illustrative and various modifications can be made to the described embodiments. The foregoing embodiments may be implemented individually or in any combination.

It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

## Claims

1. Wireless circuitry comprising:
one or more transmit circuits operable using a plurality of different mode settings;
a power detection circuit coupled to an output the one or more transmit circuits;
a plurality of power integrators; and
a first switching circuit having an input configured to receive a measured power level from the power detection circuit and having outputs coupled to the plurality of power integrators, wherein the first switching circuit has a switch state that is adjusted based on a current mode setting in the plurality of different mode settings for the one or more transmit circuits.

2. The wireless circuitry of claim 1, further comprising:
a mode controller configured to output a control word, wherein the control word determines the current mode setting for the one or more transmit circuits; and
a switch controller configured to receive the control word from the mode controller and adjust the switch state of the first switching circuit.

3. The wireless circuitry of claim 1 or claim 2, wherein the plurality of power integrators comprises:
a first power integrator having an input coupled to the first switching circuit and configured to produce a first integrated power level; and
a second power integrator having an input coupled to the first switching circuit and configured to produce a second integrated power level.

4. The wireless circuitry of claim 3, further comprising:
a first comparator having a first input configured to receive the first integrated power level from the first power integrator; and
a second comparator having a first input configured to receive the second integrated power level from the second power integrator.

5. The wireless circuitry of claim 4, further comprising:
a second switching circuit configured to provide a first target power level to a second input of the first comparator and a second target power level to a second input of the second comparator, wherein the second switching circuit has a switch state that is adjusted based on the current mode setting for the radio-frequency amplifier.

6. The wireless circuitry of claim 5, further comprising:
a third switching circuit having an first input configured to receive a first power correction signal from the first comparator and a second input configured to receive a second power correction signal from the second comparator, wherein the third switching circuit has a switch state that is adjusted based on another mode setting, different than the current mode setting, in the plurality of different mode settings for the radio-frequency amplifier.

7. The wireless circuitry of claim 6, wherein the third switching circuit has an output coupled to the one or more transmit circuits.

8. The wireless circuitry of any preceding claim, wherein:
a first mode setting in the plurality of different mode settings is used when the wireless circuitry is processing signals in accordance with a first modulation scheme; and
a second mode setting in the plurality of different mode settings is used when the wireless circuitry is processing signals in accordance with a second modulation scheme different than the first modulation scheme.

9. The wireless circuitry 8, wherein:
the first modulation scheme comprises quadrature phase shift keying (QPSK); and
the second modulation scheme comprises 64-quadature amplitude modulation (64-QAM), 128-quadrature amplitude modulation (128-QAM), 256-quadrature amplitude modulation (256-QAM), 512-quadrature amplitude modulation (512-QAM), or 1024-quadrature amplitude modulation (1024-QAM).

10. The wireless circuitry of any of claims 1 to 7, wherein:
a first mode setting in the plurality of different mode settings is used to bias a radio-frequency amplifier in the one or more transmit circuits with a first bias setting; and
a second mode setting in the plurality of different mode settings is used to bias the radio-frequency amplifier with a second bias setting different than the first bias setting.

11. Wireless circuitry comprising:
a radio-frequency amplifier operable using a plurality of different bias settings;
a power detection circuit coupled to an output of the radio-frequency amplifier;
a plurality of power integrators; and
a first switching circuit having an input configured to receive a measured power level from the power detection circuit and having outputs coupled to the plurality of power integrators, wherein the first switching circuit has a switch state that is adjusted based on a current bias setting in the plurality of different bias settings for the radio-frequency amplifier.

12. The wireless circuitry of claim 11, further comprising:
a bias circuit configured to output one or more bias signals to the radio-frequency amplifier based on a control word that at least partially determines the current bias setting for the radio-frequency amplifier.

13. The wireless circuitry of claim 12, further comprising:
a bias controller configured to output the control word; and
a switch controller configured to receive the control word from the bias controller and adjust the switch state of the first switching circuit.

14. The wireless circuitry of any of claims 11 to 13, wherein the plurality of power integrators comprises:
a first power integrator having an input coupled to the first switching circuit and configured to produce a first integrated power level; and
a second power integrator having an input coupled to the first switching circuit and configured to produce a second integrated power level.

15. The wireless circuitry of claim 14, further comprising:
a first comparator having a first input configured to receive the first integrated power level from the first power integrator;
a second comparator having a first input configured to receive the second integrated power level from the second power integrator;
a second switching circuit configured to provide a first target power level to a second input of the first comparator and a second target power level to a second input of the second comparator, wherein the second switching circuit has a switch state that is adjusted based on the current bias setting for the radio-frequency amplifier;
a third switching circuit having an first input configured to receive a first power correction signal from the first comparator and a second input configured to receive a second power correction signal from the second comparator, wherein the third switching circuit has a switch state that is adjusted based on another bias setting, different than the current bias setting, in the plurality of different bias settings for the radio-frequency amplifier; and
a gain control circuit coupled to an output of the third switching circuit and configured to output signals to the radio-frequency amplifier.
